# EUROPÄISCHE PATENTSCHRIFT

(11) **EP 0 773 310 B1**
(45) Veröffentlichungstag und Bekanntmachung des Hinweises auf die Patenterteilung: **12.07.2000**
(21) Anmeldenummer: 96114365.8
(22) Anmeldetag: 07.09.1996
(51) Int. Cl.: C30B 31/02, C30B 31/16

(54) **Verfahren zur Herstellung einer Siliziumscheibe**
Process for producing a silicon wafer
Procédé pour la production d'une tranche de silicium

(30) Priorität: 17.10.1995 DE 19538612
(43) Veröffentlichungstag der Anmeldung: 14.05.1997
(73) Patentinhaber: ROBERT BOSCH GMBH, 70442 Stuttgart (DE)
(72) Erfinder: Goebel, Herbert, Dr. Dr. rer.nat., 72766 Reutlingen (DE); Goebel, Vesna, 72766 Reutlingen (DE)

(56) Entgegenhaltungen:
- EP-A- 0 350 531
- DE-A- 3 207 870
- DE-B- 1 302 351
- US-A- 3 956 036

## Beschreibung

### Stand der Technik

Die Erfindung geht aus von einem Verfahren zur Herstellung einer Siliziumscheibe nach der Gattung des unabhängigen Patentanspruchs. Aus der EP 350 531 B1 ist bereits ein Verfahren zur Herstellung einer derartigen Siliziumscheibe bekannt, bei dem auf einer Siliziumscheibe eine Dotierstoffolie aufgebracht wird und in einem nachfolgenden Diffusionsschritt eine große Menge eines Dotierstoffs in die Siliziumscheibe abgegeben wird. Das Verfahren wird gleichzeitig auf beiden Seiten des Siliziumwafers angewendet.

### Vorteile der Erfindung

Das erfindungsgemäße Verfahren mit den kennzeichnenden Merkmalen des unabhängigen Patentanspruchs hat demgegenüber den Vorteil, daß auf einer Seite des Siliziumwafers nur eine geringe Menge an Dotierstoffen eingebracht wird. Eine sich dadurch ausbildende Diffusionszone weist daher nur eine schwache Dotierung und eine geringe Eindringtiefe auf. Diese Schicht läßt sich daher in weiteren Prozeßschritten besonders einfach entfernen, ohne daß damit ein großer Verlust an Siliziummaterial verbunden wäre.

Durch die in den abhängigen Ansprüchen aufgeführten Maßnahmen sind weitere vorteilhafte Weiterbildungen und Verbesserungen des Verfahrens nach dem unabhängigen Anspruch möglich. Durch die Anordnung einer Vielzahl von Siliziumscheiben in einem Stapel können bei geringem Verbrauch von Dotierungs- und Neutralfolien eine Vielzahl von Siliziumscheiben gleichzeitig bearbeitet werden. Durch das Herausschneiden der Siliziumscheiben aus einem Siliziumeinkristall durch eine Drahtsäge weisen die Siliziumscheiben Oberflächen auf, die im besonderen Maße für die Foliendiffusion geeignet sind. Es kann so der Materialverbrauch an Silizium verringert werden und die Zahl der notwendigen Nachbearbeitungsschritte kann verringert werden. Die Nachbearbeitung der Oberfläche der Siliziumscheibe, die der Neutralfolie zugewandt war, erfolgt besonders einfach durch läppen und polieren. Mit diesen Bearbeitungsmethoden ist nur geringer Materialverbrauch verbunden.

### Zeichnungen

Ausführungsbeispiele der Erfindung sind in den Zeichnungen dargestellt und in der nachfolgenden Beschreibung näher erläutert. Es zeigen Figur 1 das Drahtsägen von der Siliziumscheibe aus einem Siliziumeinkristall, Figur 2 einen Stapel von Siliziumscheiben mit dazwischen angeordneten Folien Figur 3 eine einzelne Siliziumscheibe nach dem Diffusionsschritt und Figur 4 nach dem Entfernen der schwach dotierten Vorderseitenschicht.

### Beschreibung

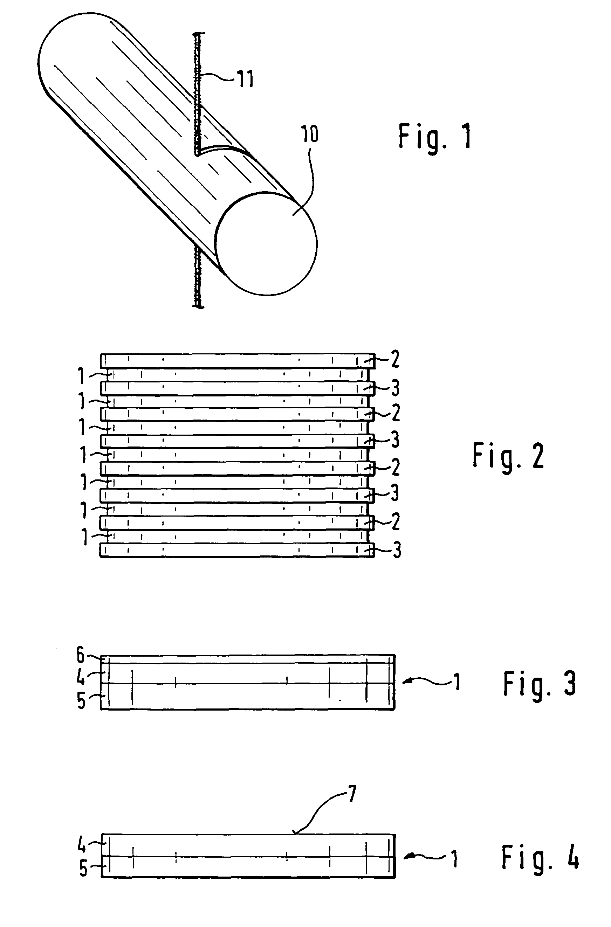

In der Figur 1 wird ein Siliziumeinkristall 10 gezeigt, aus dem durch eine Drahtsäge 11 einzelne Siliziumscheiben herausgeschnitten werden. Derartige Siliziumscheiben werden in der Regel auch als Siliziumwafer bezeichnet. Die Drahtsäge 11 besteht aus einem Schneiddraht der mit großer Geschwindigkeit bewegt wird. Auf dem Draht sind Schneidpartikel, beispielsweise Diamantstaub aufgebracht. Durch diese Form des Zerschneiden des Siliziumeinchristall 10 werden Siliziumscheiben 1 gewonnen, die eine gute Oberflächenqualität aufweisen. Die derart aus dem Siliziumeinkristall 10 herausgeschnittenen Siliziumscheiben 1 können nach einem Reinigungsschritt unmittelbar weiterverarbeitet werden, ohne daß ein weiterer Abtragschritt der Oberfläche zur Verbesserung der Oberflächenqualität der Siliziumscheiben 1 erförderlich ist. Weiterhin weisen die so erzeugten Oberflächen eine gewisse Microrauhigkeit auf, die ein Eindringen von Dotierstoffen begünstigt.

In der Figur 2 wird die weitere Bearbeitung der so gewonnenen Siliziumscheiben 1 gezeigt. Jede Siliziumscheibe 1 weist zwei Seiten auf, deren Oberflächen durch Drahtsägen gebildet sind. Auf eine dieser Oberflächen wird eine Diffusionsfolie 2 und auf die andere eine Neutralfolie 3 aufgebracht. Die Diffusionsfolie ist, wie in der EP 350 531 beschrieben wird, aus einem organischen Binder, einem anorganischen Binder und einem Dotierstoff aufgebaut. Die Dotierstoffkonzentration wird dabei möglichst hoch gewählt, um eine starke Dotierung der Siliziumscheiben 1 zu erreichen. Die Neutralfolien 2 bestehen im Wesentlichen aus einem organischen Binder und einem anorganischen Binder. Idealerweise enthält die Neutralfolie 2 keinerlei Dotierstoffe die eine Dotierung der Siliziumscheiben 1 bewirken können. In der Praxis läßt sich eine dotierstoffreie Neutralfolie 2 nur schwer erreichen. Störend ist dabei vor allen Dingen, daß nicht reproduzierbar voraussagbar ist, welche Verunreinigungen vorhanden sind. Daher ist auch für die Neutralfolie eine geringe Menge von Dotierstoff vorgesehen um eine geringe, dafür exakt einstellbare Dotierung der Siliziumscheibe 1 auf der der Neutralfolie 2 zugewandten Seite zu erreichen. Wie in der Figur 2 gezeigt wird, werden zweckmäßiger Weise eine Vielzahl von Siliziumplatten 1 mit einer Vielzahl von Diffusionsfolien 2 und Neutralfolien 3 in einem Stapel angeordnet. Dabei wird, abgesehen von der oberen und der unteren Folie, jede Diffusionsfolie 2 und jede Neutralfolie 3 zwischen 2 Siliziumscheiben 1 angeordnet. Die benötigte Zahl von Folien wird somit gering gehalten und es können eine Vielzahl von Siliziumscheiben 1 in einem Diffusionsschritt bearbeitet werden. Der in der Figur 2 gezeigte Stapel wird anschließend bei einer hohen Temperatur, beispielsweise 1250°C, in einem Diffusionsofen diffundiert. Dabei zerfällt der organische Binder und der Diffusionsstoff dringt in die Oberflächen der Siliziumscheiben 1 ein. Ein unmittelbares Aufeinanderliegen der Siliziumscheiben 1 wird dabei durch den anorganischen Binder verhindert. Durch eine ausreichend lange Diffusionszeit wird dann der Dotierstoff in die Tiefe der Siliziumscheiben 1 eingetrieben. Nach der Diffusion werden die einzelnen Siliziumscheiben 1 voneinander getrennt.

In der Figur 3 ist eine derartige Siliziumscheibe 1 unmittelbar nach der Diffusion dargestellt. Die Siliziumscheibe 1 weist auf der Unterseite eine relativ dicke Diffusionszone auf, die durch die Dotierstoffe einer Dotierfolie 2 hervorgerufen sind. Eine mittlere Zone 4 weist noch die ursprüngliche Dotierung der Siliziumscheibe 1 bzw. des Siliziumeinkristall 10 auf. Auf der Oberseite ist eine relativ dünne Dotierzone 6 angeordnet, die durch die Dotierstoffe der Neutralfolie 2 hervorgerufen ist. Wegen des starken Unterschieds in der Dotierstoffkonzentration und der Struktur der Dotierfolien ist die Diffusionszone auf der Unterseite der Siliziumscheibe 1 wesentlich tiefer in die Siliziumscheibe 1 eingedrungen als die Diffusionszone, die sich ausgehend von der Oberseite der Siliziumscheibe 1 erstreckt.

In der Figur 4 wird die Siliziumscheibe 1 nach einem weiteren Bearbeitungsschritt gezeigt, bei dem die obere Schicht 6 entfernt wurde. Dies geschieht beispielsweise durch läppen und polieren, so daß dann eine besonders glatte Oberseite 7 entsteht, die für eine nachfolgende Weiterbearbeitung zur Herstellung von Halbleiterelementen, beispielsweise Lithographieschritten besonders gut geeignet ist.

Das Verfahren ist besonders gut zur Herstellung von sog. rückseitendiffundierten Wafern geeignet. Ein derartiger Wafer ist eine Siliziumscheibe wie sie in der Figur 4 dargestellt wird, wobei die obere Schicht 4 eine geringe Dotierung und die untere Schicht 5 eine starke Dotierung des gleichen Leitfähigkeitstyp aufweist wie die obere Schicht 4. Derartige Siliziumwafer finden insbesondere für die Herstellung von Dioden und Leistungstransistoren Verwendung. Dabei ist es wünschenswert, daß die untere Schicht 5, die stark dotiert ist und somit einen besonderes geringen Widerstand aufweist, möglichst dick wird. Es sind daher hohe Dotierstoffkonzentrationen und lange Diffusionszeiten erforderlich. Die obere Schicht 4 soll jedoch im Unterschied dazu nur eine geringe Dotierung aufweisen. Wenn die untere Schicht 5 durch einen Diffusionsprozeß eingebracht wird, muß vermieden werden, daß auf der Oberseite der Siliziumplatte 1 ebenfalls eine stark dotierte Schicht eingebracht wird. Im vorliegenden Verfahren wird dies besonders einfach dadurch erreicht, daß eine Neutralfolie mit einer besonders geringen Dotierstoffkonzentration verwendet wird. Weiterhin ist es möglich, für die geringe Dotierstoffkonzentration der Neutralfolie einen Dotierstoff des entgegengesetzten Leitungstyps zu verwenden, so daß in dem Zwischenschritt wie er in der Figur 3 gezeigt wird, die obere Schicht 6 beispielsweise eine P-Dotierung und die beiden unteren Schichten 4 und 5 beispielsweise eine N-Dotierung aufweisen. Die obere P-dotierte Schicht läßt sich dann besonderes einfach durch einen selektiven Ätzprozeß entfernen. Als Dicke der oberen Schicht 6 ist dann der PN-Übergang zwischen der P-dotierten oberen Schicht 6 und der N-dotierten Schicht 4 zu verstehen. Aufgrund der geringen Dotierstoff-konzentration der Neutralfolie 2 ist nur eine dünne oberflächliche Schicht P-dotiert, so daß nur eine geringe Dicke des Siliziumwafers 1 abgetragen werden muß. Das Verfahren ist daher besonders sparsam. Weiterhin wird der Verbrauch an Siliziummaterial auch durch das erfindungsgemäße Drahtsägen gering gehalten, da die Schnittbreite beim Drahtsägen besonders gering gehalten werden kann. Da weiterhin die Beschädigung der Oberfläche beim Drahtsägen deutlich geringer ist als die Schädigung durch das herkömmliche Sägen einer Innenlochsäge können die Siliziumscheiben nach dem Sägen unmittelbar für die Diffusion genutzt werden ohne daß weitere Bearbeitungsschritte, bei denen in der Regel Siliziummaterial abgetragen wird, erforderlich sind. Durch die Kombination von Drahtsägen und Foliendiffusion wird somit ein besonders geringer Verlust von Siliziummaterial erreicht.

## Patentansprüche

1. Verfahren zur Herstellung einer Siliziumscheibe, wobei auf einer Seite der Siliziumscheibe eine Dotierstoffolie mit einer hohen Dotierstoffkonzentration aufgebracht wird und einem nachfolgenden Diffusionschritt unterzogen wird, dadurch gekennzeichnet, daß während des Diffusionsschritts auf einer weiteren Seite der Siliziumscheibe eine Neutralfolie (3) aufgebracht ist, die nur eine geringe Dotierstoffkonzentration aufweist, so daß auf dieser weiteren Seite weitestgehend eine Dotierung vermieden wird bei gleichzeitiger Reproduzierbarkeit des Eindringens von Verunreinigungen.

2. Verfahren nach Anspruch 1, dadurch gekennzeichnet, daß beim Diffusionsschritt eine Vielzahl von Siliziumscheiben (1) in einem Stapel zusammen mit Diffusionsfolien (2) und Neutralfolien (3) angeordnet werden.

3. Verfahren nach einem der vorhergehenden Ansprüche, dadurch gekennzeichnet, daß die Siliziumscheiben (1) durch Drahtsägen aus einem Siliziumeinkristall (10) herausgeschnitten und ohne weiteren Silizium-Abtrag mit einer Diffusion weiterbehandelt werden.

4. Verfahren nach einem der vorhergehenden Ansprüche, dadurch gekennzeichnet, daß die Siliziumscheiben (1) nach dem Diffusionsschritt auf der den Neutralfolie (2) zugewandten Seite der Siliziumscheiben durch läppen und polieren nachbearbeitet werden.

5. Verfahren nach einem der vorhergehenden Ansprüche, dadurch gekennzeichnet, daß die Siliziumscheiben vor dem Diffusionsschritt eine, im wesentlichen gleichmäßige , geringe Dotierung eines ersten Leitfähigkeitstyps aufweisen und daß die Dotierstoffolien (2) einen Dotierstoff für den ersten Leitfähigkeitstyp aufweisen.

6. Verfahren nach einem der vorhergehenden Ansprüche, dadurch gekennzeichnet, daß die Neutralfolien (3) eine geringe Konzentration eines Dotierstoffs (5) eines zweiten Leitfähigkeitstyps aufweisen.

## Claims

1. Process for producing a silicon wafer, a dopant film with a high dopant concentration being applied on one side of the silicon wafer and being subjected to a subsequent diffusion step, characterized in that, during the diffusion step, a neutral film (3) is applied on a further side of the silicon wafer, the said neutral film having only a low dopant concentration, with the result that, on this further side, doping is avoided to the greatest possible extent, in conjunction with reproducibility of the penetration of impurities.

2. Process according to Claim 1, characterized in that, during the diffusion steps, a multiplicity of silicon wafers (1) are arranged in a stack together with diffusion films (2) and neutral films (3).

3. Process according to one of the preceding claims, characterized in that the silicon wafers (1) are cut from a silicon single crystal (10) by wire sawing and are treated further by diffusion with no further removal of silicon.

4. Process according to one of the preceding claims, characterized in that, after the diffusion step, the silicon wafers (1) are post-processed by lapping and polishing on that side of the silicon wafers which faces the neutral film (2).

5. Process according to one of the preceding claims, characterized in that, before the diffusion step, the silicon wafers have an, essentially uniform, low doping of a first conductivity type, and in that the dopant films (2) have a dopant for the first conductivity type.

6. Process according to one of the preceding claims, characterized in that the neutral films (3) have a low concentration of a dopant (5) of a second conductivity type.

## Revendications

1. Procédé de fabrication d'une plaquette de silicium selon lequel, sur une face de la plaquette de silicium on applique une feuille de dopage ayant une forte concentration de matière de dopage et on la soumet ensuite à une étape de diffusion,
caractérisé en ce que
pendant l'étape de diffusion, on applique, sur l'autre face de la plaquette de silicium, une feuille neutre (3) qui ne présente qu'une faible concentration de matière dopante pour que sur cette autre face on évite dans une très large mesure le dopage tout en ayant la reproductibilité de la pénétration des impuretés.

2. Procédé selon la revendication 1,
caractérisé en ce que
dans l'étape de diffusion, on empile un grand nombre de plaquettes de silicium (1) avec des feuilles de diffusion (2) et des feuilles neutres (3).

3. Procédé selon l'une quelconque des revendications précédentes,
caractérisé en ce qu'
on découpe les plaquettes de silicium (1) avec des scies à fil dans un monocristal de silicium (10) et on les soumet à la diffusion sans autre enlèvement de silicium.

4. Procédé selon l'une des revendications précédentes,
caractérisé en ce qu'
après l'étape de diffusion, on usine la face de la plaquette de silicium (1) tournée vers la feuille neutre (2) par rodage et polissage.

5. Procédé selon l'une des revendications précédentes,
caractérisé en ce que
les plaquettes de silicium présentent, avant l'étape de diffusion, un dopage faible essentiellement régulier d'un premier type de conductivité, et les feuilles de dopage (2) contiennent une matière dopante pour le premier type de conductivité.

6. Procédé selon l'une quelconque des revendications précédentes,
caractérisé en ce que
la feuille neutre (3) a une faible concentration en matière dopante (5) d'un second type de conductivité.
